(19) Europäisches Patentamt

European Patent Office

Office européen des brevets

(11) **EP 2 051 088 A1**

(12) **EUROPÄISCHE PATENTANMELDUNG**

(43) Veröffentlichungstag:
  **22.04.2009 Patentblatt 2009/17**

(51) Int Cl.:
  *G01R 31/36* (2006.01)     *G01R 1/20* (2006.01)
  *G08B 13/00* (2006.01)

(21) Anmeldenummer: **07118689.4**

(22) Anmeldetag: **17.10.2007**

(84) Benannte Vertragsstaaten:
  **AT BE BG CH CY CZ DE DK EE ES FI FR GB GR HU IE IS IT LI LT LU LV MC MT NL PL PT RO SE SI SK TR**
  Benannte Erstreckungsstaaten:
  **AL BA HR MK RS**

(71) Anmelder: **Siemens Schweiz AG**
  **8047 Zürich (CH)**

(72) Erfinder: **Waldmeier, Christoph**
  **8853, Lachen (CH)**

(54) **Bestimmung des Innen- und Anschlusswiderstandes einer Batterie**

(57)   Es wird ein Verfahren zum Bestimmen des Innen- und Anschlusswiderstandes einer Batterie (110), insbesondere einer Batterie (110) für die Netzspeisung einer Zentrale (102) und/oder Peripherieeinheit (103) eines Gefahrmeldesystems (100) beschrieben. Das Verfahren weist auf (a) ein vorübergehendes Belasten der Batterie (110) mit einem Messstrom, welcher über einen Messwiderstand (122) geleitet wird, (b) ein Messen der an dem Messwiderstand (122) abfallenden Spannung ($U_A$), und (c) ein Bestimmen des Innen- und Anschlusswiderstandes ($R_I+R_K$) der Batterie (110) basierend auf der gemessenen Spannung ($U_A$). Dabei führt der Messstrom zu einer vorübergehenden Belastung des Messwiderstands (122) mit einer Messleistung, welche größer ist als die Nennleistung des Messwiderstands (122). Bevorzugt weist der Messwiderstand (122) einen Widerstandswert auf, welcher um einen Faktor 5, insbesondere um einen Faktor 10 und bevorzugt um einen Faktor 50 größer ist als der zu erwartende Innen- und Anschlusswiderstand ($R_I+R_K$) der Batterie (110). Es wird ferner eine Schaltungsanordnung (120) und ein Gefahrmeldesystem (100) beschrieben, welche zur Durchführung des genannten Messverfahrens geeignet sind.

FIG 1

EP 2 051 088 A1

**Beschreibung**

Die vorliegende Erfindung betrifft ein Verfahren zum Bestimmen des Innen- und Anschlusswiderstandes einer Batterie, welche insbesondere für die Netzspeisung einer Zentrale und/oder einer Peripherieeinheit eines Gefahrmeldesystems vorgesehen ist. Die vorliegende Erfindung betrifft ferner eine Schaltungsanordnung zum Bestimmen des Innen- und Anschlusswiderstandes einer Batterie. Außerdem betrifft die vorliegende Erfindung ein Gefahrmeldesystem, welches zumindest eine Schaltungsanordnung des oben genannten Typs aufweist.

Bei Gefahrmeldesystemen, welche üblicherweise eine Zentrale und eine Mehrzahl von Peripherieeinheiten aufweisen, wird eine hohe Ausfallsicherheit gefordert, um auch in einem Gefahrenfall einen zuverlässigen Betrieb eines Gefahrmeldesystems zu gewährleisten. So ist es beispielsweise erforderlich, dass ein Gefahrmeldesystem auch dann noch zumindest für eine vorgegebene Zeitspanne funktionsbereit ist, wenn eine Stromversorgung für die Zentrale und/ oder für die Peripherieeinheiten unterbrochen ist. So gibt es beispielsweise eine Vorschrift, gemäß der für eine Komponente eines Gefahrmeldesystems zwei voneinander unabhängige Stromversorgungen nötig sind, von denen eine üblicherweise eine wieder aufladbare Batterie ist. Auf diese Weise kann sichergestellt werden, dass in einem Gefahrenfall wie beispielsweise ein Brand in einem Gebäude, die in dem Gebäude befindlichen Personen durch Beachtung geeignete Warnhinweise wie beispielsweise akustische und/oder optische Alarmsignale den Gefahrenbereich möglichst schnell und auf einem geeigneten Weg möglichst sicher verlassen können.

Für eine Überprüfung der Zuverlässigkeit eines Gefahrmeldesystems ist es insbesondere wichtig, dass der Zustand von wieder aufladbaren Batterien regelmäßig überprüft wird, welche eine Funktion der entsprechenden Komponenten des Gefahrmeldesystems auch im Falle einer Unterbrechung der Stromversorgung sicherstellen. Dazu ist es erforderlich in regelmäßigen Abständen den Innenwiderstand einer Batterie der Anschaltung zu messen, wobei ein erhöhter Widerstandswert ein eindeutiger Hinweis für eine Alterung und damit für eine reduzierte Leistung der Batterie ist.

Ein derartiges Messverfahren zum Bestimmen des Innenwiderstandes einer wieder aufladbaren Batterie ist insbesondere in Verbindung mit der Speisung von Gefahrenmeldezentralen, vorzugsweise Brandmelde-, Intrusions- oder Gaswarnzentralen, von Bedeutung und wird neuerdings von der Norm EN 54-4:1997/prA2:2006 (D) [Anhang A] vorgeschrieben.

Im Bereich der Gefahrmeldetechnik wurde das Altern einer wieder aufladbaren Batterie beispielsweise durch Belastung mit einem hohen Messstrom festgestellt, welcher jedoch eine Kühlung des verwendeten Messwiderstands und ggf. einer geeigneten Messschaltung erfordert. Im Falle der Kühlung einer Messschaltung kann es beispielsweise erforderlich sein, eine einen Feldeffekttransistor aufweisende Stromquelle zu kühlen. Die Bereitstellung einer Kühlung bedeutet jedoch einen hohen Zusatzaufwand.

Der vorliegenden Erfindung liegt die Aufgabe zugrunde, ein Verfahren und eine Schaltungsanordnung anzugeben, welche die Bestimmung des Innen- und Anschlusswiderstandes einer Batterie mit einem geringen apparativen Aufwand ermöglichen.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird ein Verfahren zum Bestimmen des Innen- und Anschlusswiderstandes einer Batterie beschrieben, welches insbesondere für eine Batterie für die Netzspeisung einer Zentrale und/ oder Peripherieeinheit eines Gefahrmeldesystems geeignet ist. Das beschriebene Verfahren weist auf (a) ein vorübergehendes Belasten der Batterie mit einem Messstrom, welcher über einen Messwiderstand geleitet wird, (b) ein Messen der an dem Messwiderstand abfallenden Spannung, und (c) ein Bestimmen des Innen- und Anschlusswiderstandes der Batterie basierend auf der gemessenen Spannung. Dabei führt der Messstrom zu einer vorübergehenden Belastung des Messwiderstands mit einer Messleistung, welche größer ist als die Nennleistung des Messwiderstands. Die Messleistung ist somit als Pulslast zugelassen.

Dem beschriebenen Verfahren liegt die Erkenntnis zugrunde, dass die Messung des Innen- und Anschlusswiderstandes der Batterie auch mittels eines Messwiderstandes erfolgen kann, welcher im Vergleich zu der Verlustleistung, die im Verlauf der Messung verbraucht wird, eine geringe Leistung aufweist. Dies bedeutet, dass die Nennleistung bzw. die in Datenblättern angegebenen maximale Verlustleistung des Messwiderstandes kurzzeitig überschritten wird. Da der gesamte Messvorgang jedoch nur eine kurze Zeitdauer von bevorzugt weniger als eine einzige Sekunde benötigt, führt die kurzzeitige thermische Überlastung des Messwiderstands nicht zu dessen Zerstörung. Die Leistung des Messwiderstandes kann also so weit reduziert werden, dass gerade noch eine brauchbare Widerstandsmessung durchgeführt werden kann.

Die erfindungsgemäße kurzzeitige Überlastung des Messwiderstands hat den Vorteil, dass der Innen- und Anschlusswiderstandes einer Batterie mittels einer einfachen Spannungsteilung gemessen wird, für die lediglich ein Widerstand mit vergleichsweise geringer Leistung erforderlich ist. Die erfindungsgemäße Widerstandsbestimmung kann somit mit billigen elektronischen Bauelementen realisiert werden, welche zudem auf einfache Weise in bekannte Zentralen und/oder Peripherieeinheiten eingebaut werden können. Eine aufwendige Kühlung des Messwiderstands ist wegen seiner geringen Leistung nicht erforderlich.

Durch eine regelmäßige Bestimmung des Innenwiderstandes einer Batterie, welche im Fall eines Ausfalls des Stromnetzes zumindest für einen vorgegebenen Zeitraum einen ungestörten Betrieb eines Gefahrmeldesystems gewährleistet, kann eine normierte Vorschrift für künftige Gefahrmeldesysteme erfüllt werden. Diese Norm, welche den einschlägigen Fachkreisen unter der Bezeichnung EN54-4:1997/prA2:2006(D) bekannt ist, schreibt nämlich eine regelmäßige Überprüfung des Innen- und Anschlusswiderstandes von Batterien vor, um eine Reduzierung der Leistung der Batterien frühzeitig erkennen zu können. Bei einer unzulässigen Erhöhung des Innen- und Anschlusswiderstandes einer Batterie fällt nämlich im strombelasteten Fall über dem Innen- und Anschlusswiderstand eine gewisse Spannung ab, welche die für den Betrieb der Zentrale und/oder der Peripherieeinheiten erforderliche Spannung in unzulässiger Weise reduzieren kann, so dass ein zuverlässiger Betrieb von Zentrale und/oder Peripherieeinheiten über einen geforderten Zeitraum bei einem Stromausfall nicht mehr sicher gewährleistet werden kann.

Unter dem Begriff Batterie ist im Rahmen dieser Anmeldung allgemein ein Energiespeicher zu verstehen, welcher in der Lage ist, einem Verbraucher eine elektrische Energie bereit zu stellen. Die Batterie kann insbesondere ein wieder aufladbarer Akku sein.

Die Gefahrenmeldezentrale kann beispielsweise eine Brandmeldezentrale, eine Intrusions- bzw. Einbruchsmeldezentrale oder eine Gaswarnmeldezentrale sein. Die Peripherieeinheit kann eine beliebige Wandlervorrichtung sein, welche eine Eingangsgröße in eine Ausgangsgröße umwandelt. Im Bereich der Gefahrmeldetechnik kann die Peripherieeinheit eine Meldeeinrichtung wie beispielsweise ein Sensor, eine optische und/oder akustische Evakuiersteuerung bzw. Evakuierhilfe, eine optische und/oder eine akustische Anzeigeeinrichtung oder jedes andere Gerät sein, welches in einem Gefahrfall Personen beim Verlassen des Gefahrenbereichs unterstützt. Als Sensoren kommen beispielsweise Brand-, Rauch-, Temperatur-, Geruchs- und/oder chemische Detektoren in Betracht, welche abhängig von der jeweiligen Gefährdung eine Gefahrensituation erkennen können.

Gemäß einem Ausführungsbeispiel der Erfindung wird während der Belastung der Batterie mit dem Messstrom ein an der Batterie angeschlossener Verbraucher abgekoppelt. Dies hat den Vorteil, dass die Messung des Spannungsabfalls an dem Messwiderstand nicht durch andere elektronische Bauelemente, die dem Verbraucher zugeordnet sind, verfälscht wird. Der Verbraucher kann beispielsweise die Zentrale und/oder eine Peripherieeinheit eines Gefahrmeldesystems sein.

Gemäß einem weiteren Ausführungsbeispiel der Erfindung weist der Messwiderstand einen Widerstandswert auf, welcher um einen Faktor 10, insbesondere um einen Faktor 50 und bevorzugt um einen Faktor 100 größer ist als der zu erwartende Innen- und Anschlusswiderstand der Batterie.

Der Messwiderstand kann somit ein einfacher Widerstand sein, welcher im Vergleich zu bekannten Lösungen zum Messen eines Innenwiderstandes den Messstrom erheblich reduziert. Bei bekannten Lösungen zur Bestimmung eines Innenwiderstandes wird nämlich typischerweise ein Messwiderstand gewählt, welcher im Vergleich zu dem zu messenden bzw. zu dem zu erwartenden Innen- und Anschlusswiderstand einen vergleichbar großen Widerstandswert hat. Durch die beschriebene Reduzierung der Stromstärke des Messstroms wird somit ein geeigneter Kompromiss gefunden zwischen (a) einer adäquaten bzw. ausreichenden Messgenauigkeit auf der einen Seite und (b) einer möglichst geringen Verlustleistung während der Batteriebelastung auf der anderen Seite.

Gemäß einem weiteren Ausführungsbeispiel der Erfindung erfolgt während des Belastens der Batterie mit dem Messstrom eine Überwachung auf einen Ausfall eines Stromversorgungsnetzes, insbesondere eines öffentlichen Stromversorgungsnetzes. Im Falle eines Ausfalls des Stromversorgungsnetzes kann das beschriebene Verfahren zum Bestimmen des Innen- und Anschlusswiderstandes somit sofort abgebrochen werden, um einen Ausfall der Gefahrmeldeanlage zu verhindern. Auf diese Weise kann eine ausreichende Spannungsversorgung für die Zentrale und/oder für die Peripherieeinheiten des Gefahrmeldesystems sichergestellt und so ein Ausfall der gesamten Gefahrmeldeanlage vermieden werden.

Gemäß einem weiteren Ausführungsbeispiel der Erfindung erfolgt der Messvorgang für die an dem Messwiderstand abfallende Spannung relativ zu dem Beginn der Belastung der Batterie mit dem Messstrom mit einer vorbestimmten ersten zeitlichen Verzögerung. Dies hat den Vorteil, dass Fehler bei der Spannungsmessung, welche beispielsweise durch induktive und insbesondere durch kapazitive Effekte verursacht werden können, zumindest annähernd vollständig vermieden werden können. Die kapazitiven Effekte treten dabei insbesondere in der Batterie auf, deren parasitäre Kapazität durch die Strombelastung und die damit verursachte Spannungsreduzierung mit einer charakteristischen Zeitkonstante teilweise entladen wird. Das ganze System befindet sich nach Ablauf der ersten zeitlichen Verzögerung somit in einem weitgehend eingeschwungenem bzw. stationären Zustand.

Gemäß einem weiteren Ausführungsbeispiel der Erfindung wird die Zeitdauer des Messstroms so gewählt, dass die resultierende Wärmebelastung des Messwiderstands in einem für den Messwiderstand tolerierbaren Bereich liegt. Durch eine geeignete zeitliche Begrenzung des Messstroms kann somit eine versehentliche thermische Beschädigung des Messwiderstands verhindert werden.

Gemäß einem weiteren Ausführungsbeispiel der Erfindung weist das Verfahren zusätzlich auf (a) ein Unterbinden eines Stromflusses durch den Messwiderstand und (b) eine Messung der Spannung der Batterie im stromlosen Zustand.

Die zusätzliche Messung der Batteriespannung im stromlosen Zustand hat den Vorteil, dass weder an dem Innenwiderstand noch an dem Anschlusswiderstand ein Spannungsabfall erzeugt wird. Damit kann auf einfache Weise die Batteriespannung nach dem vorübergehenden Belasten der Batterie mit dem Messstrom mit einer hohen Genauigkeit gemessen werden. Die genaue Kenntnis der Batteriespannung kann bei einer Berechnung des Innen- und Anschlusswiderstandes der Batterie verwendet werden, wobei die Berechnung auf bekannten Prinzipien der Spannungsteilung entlang in Serie geschalteten Widerständen beruht. Die in Serie geschalteten Widerstände sind dabei zumindest (a) der Innenwiderstand, (b) der Anschlusswiderstand und (c) der Messwiderstand.

Gemäß einem weiteren Ausführungsbeispiel der Erfindung erfolgt die Berechnung des Innen- und des Anschlusswiderstandes nach folgender Formel:

$$R_I + R_K = [R_M/U_A(T_2)] \times [U_A(T_3) - U_A(T_2)]$$

Dabei stehen die Parameter $R_I$ für den Innenwiderstand der Batterie, $R_K$ für den Widerstand von Kabel und Anschlüssen der Batterie, $U_A(T_2)$ für die Spannung über dem mit dem Messstrom belasteten Messwiderstand und $U_A(T_3)$ für die Batteriespannung im stromlosen Zustand.

Diese Formel basiert auf der Grundlage einer einfachen Spannungsteilung. Auf vorteilhafte Weise werden zur Bestimmung des Innen- und Anschlusswiderstandes der Batterie somit lediglich Spannungen und Widerstände bzw. deren Verhältnisse verwendet. Direkte Strommessungen sind nicht erforderlich.

Gemäß einem weiteren Ausführungsbeispiel der Erfindung erfolgt der Messvorgang für die Spannung der Batterie im stromlosen Zustand relativ zu der Unterbindung des Stromflusses durch den Messwiderstand in einer vorbestimmten zweiten zeitlichen Verzögerung. Dies hat den Vorteil, dass Fehler bei der Spannungsmessung, welche beispielsweise durch induktive und insbesondere durch kapazitive Effekte verursacht werden können, zumindest annähernd vollständig vermieden werden können. Die kapazitiven Effekte treten dabei insbesondere in der Batterie auf, deren parasitäre Kapazität durch eine durch die Stromunterbrechung verursachte Spannungserhöhung mit der oben genannten charakteristischen Zeitkonstante wieder aufgeladen wird.

Gemäß einem weiteren Aspekt der vorliegenden Erfindung wird eine Schaltungsanordnung zum Bestimmen des Innen- und Anschlusswiderstandes einer Batterie beschrieben, welche Schaltungsanordnung insbesondere zum Durchführen des oben genannten Verfahrens geeignet ist. Die Schaltungsanordnung weist auf (a) einen Eingang zum Verbinden der Schaltungsanordnung mit der Batterie, (b) einen Messwiderstand zum Belasten der Batterie mit einem Messstrom, und (c) einen ersten Schalter zum vorübergehenden Schließen eines Stromkreises, so dass der Messstrom fließen kann. Der Messwiderstand ist dabei derart dimensioniert, dass der Messstrom zu einer vorübergehenden Belastung des Messwiderstands mit einer Messleistung führt, welche größer ist als die Nennleistung des Messwiderstands.

Der beschriebenen Schaltungsanordnung liegt die Erkenntnis zugrunde, dass auch mit einem Messwiderstand mit vergleichsweise geringer Leistung, der jedoch nur für einen relativ kurzen Zeitraum belastet wird, eine zuverlässige Messung des Innen- und Anschlusswiderstandes der Batterie erfolgen kann. Infolge der lediglich kurzzeitigen thermischen Überlastung ist eine thermische Zerstörung des Messwiderstandes auch dann nicht zu besorgen, wenn auf eine Kühlung des Messwiderstandes verzichtet wird. Damit kann im Vergleich zu bekannten Schaltungsanordnungen für eine Bestimmung von Innen- und Anschlusswiderständen der aparative Aufwand für die Messung gering gehalten werden. Die erfindungsgemäße Schaltungsanordnung kann somit mit herkömmlichen preiswerten elektronischen Bauelementen realisiert werden, welche zudem auf einfache Weise in bekannte Zentralen und/oder Peripherieeinheiten eingebaut werden können.

Gemäß einem Ausführungsbeispiel der Erfindung weist die Schaltungsanordnung zusätzlich einen zweiten Schalter zum vorübergehenden Abkoppeln von elektronischen Komponenten auf, welche üblicherweise mit der Batterie verbunden sind.

Durch eine Betätigung und insbesondere durch eine Öffnung des zweiten Schalters können somit während des zeitlich befristeten Messvorgangs weitere elektronische Komponenten von der Batterie getrennt werden. Dies hat den Vorteil, dass der Messvorgang nicht verfälscht wird.

Die elektronischen Komponenten können beispielsweise die Zentrale und/oder die Peripherieeinheiten eines Gefahrmeldesystems seins. Außerdem kann durch den zweiten Schalter auch eine Netzeinspeisung von der Schaltungsanordnung abgetrennt werden. Die elektronischen Komponenten können ferner auch Komponenten wie beispielsweise eine Steuereinheit für den ersten und/oder den zweiten Schalter und Batterieladevorrichtung sein, welche mit der Netzeinspeisung gekoppelt ist und welche derart eingerichtet ist, dass die Batterie in geeigneter Weise aufgeladen wird. Diese Komponenten können auch der beschriebenen Schaltungsanordnung zugeordnet sein.

Gemäß einem weiteren Ausführungsbeispiel der Erfindung ist der Messwiderstand mittels einer Kombination von mehreren Einzelwiderständen realisiert. Dies hat den Vorteil, dass standardisierte bzw. handelsübliche Widerstände verwendet werden können, so dass der hinsichtlich des oben beschriebenen Verfahrens zum Bestimmen des Innen- und Anschlusswiderstandes einer Batterie optimierte Messwiderstand mit preiswerten elektronischen Bauelementen realisiert werden kann.

Ein Messwiderstand mit einem Widerstandswert von 90 Ohm kann beispielsweise durch eine Serienschaltung von fünf Einzelwiderständen mit einem Widerstandswert von jeweils 18 Ohm realisiert werden. Selbstverständlich sind auch beliebige andere Kombinationen von Widerständen mit ggf. unterschiedlichen Widerstandswerten möglich, die in einer Serienschaltung, einer Parallelschaltung und/oder in einer Kombination aus zumindest einer Serienschaltung und zumindest einer Parallelschaltung angeordnet sein können.

Gemäß einem weiteren Aspekt der vorliegenden Erfindung wird ein Gefahrmeldesystem zum Erkennen und/ oder Beseitigen einer Gefahrensituation beschrieben. Das Gefahrmeldesystem weist auf (a) eine Zentrale und/oder eine Peripherieeinheit, (b) eine Batterie zum Versorgen der Zentrale und/oder der Peripherieeinheit mit elektrischer Energie, und (c) eine Schaltungsanordnung des oben beschriebenen Typs zum Bestimmen des Innen- und Anschlusswiderstandes der Batterie.

Dem genannten Gefahrmeldesystem liegt die Erkenntnis zugrunde, dass die oben beschriebene und erläuterte Schaltungsanordnung auf effektive Weise für eine regelmäßige Bestimmung des Innen- und Anschlusswiderstandes der Batterie eingesetzt werden kann. Insbesondere für den Fall, bei dem die Batterie ein wieder aufladbarer Akku ist, kann eine Alterung des Akkus somit frühzeitig erkannt werden. Dadurch können sicherheitsrelevante Vorschriften für Gefahrmeldesysteme wie beispielsweise die Norm EN54-4:1997/prA2:2006(D) auf einfache Weise erfüllt werden.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

Im Folgenden wird die Erfindung anhand eines Ausführungsbeispiels und der Zeichnungen näher erläutert.

Figur 1      zeigt ein Blockschema eines Gefahrmeldesystems mit einer Schaltungsanordnung zum Bestimmen des Innenund Anschlusswiderstandes einer Batterie zur Speisung einer Brandmeldezentrale.

Figur 2      ein Diagramm zur Funktionserläuterung eines Messvorgangs zum Bestimmen des Innen- und Anschlusswiderstandes der in Figur 1 dargestellten Batterie.

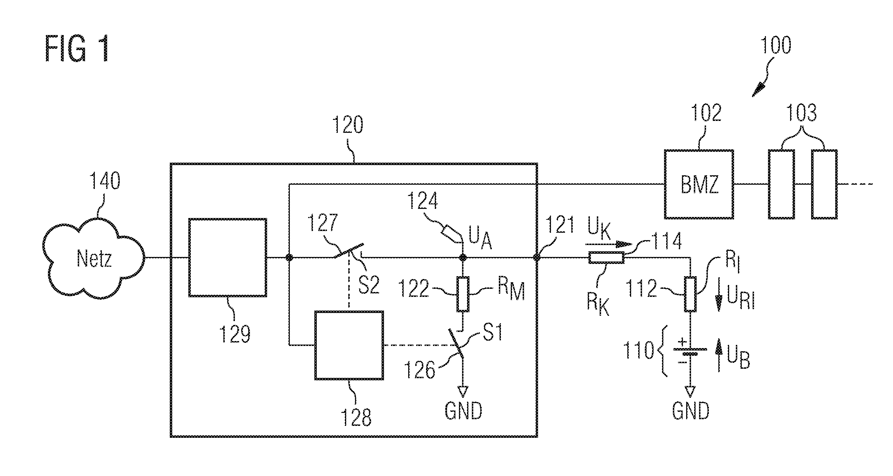

Das in Figur 1 dargestellte Gefahrmeldesystem 100 weist eine Zentrale 102 auf. Gemäß dem hier dargestellten Ausführungsbeispiel ist das Gefahrmeldesystem ein Brandmeldesystem 100. Dementsprechend handelt es sich bei der Zentrale um eine Brandmeldezentrale 100. An die Zentrale sind in bekannter Weise eine Mehrzahl von Peripherieeinheiten 103 angeschlossen, von denen in Figur 1 aus Gründen der Übersichtlichkeit lediglich zwei Peripherieeinheiten 103 dargestellt sind. Die Peripherieeinheiten 103 können Brand-, Rauch- und/oder Temperatursensoren aufweisen, so dass eine durch einen Brand verursachte Gefahrensituation schnell erkannt und an die Brandmeldezentrale 102 gemeldet werden kann.

Die Brandmeldezentrale 102 wird im ungestörten Zustand von einem öffentlichen Stromnetz 140, welches beispielsweise in Europa eine 50 Hz Wechselspannung von ca. 230 Volt liefert, mit elektrischer Energie versorgt. Um auch bei einer Unterbrechung dieser Stromversorgung, welche in einer durch einen Brand ausgelösten Gefahrensituation nicht unwahrscheinlich ist, das Gefahrmeldesystem 100 zumindest für einen vorgegebenen Zeitraum weiter betreiben zu können, ist eine wieder aufladbare Batterie 110 vorgesehen, welche die Brandmeldezentrale 102 mit elektrischer Energie versorgt.

Wie jede Batterie bzw. wie jeder Akku weist auch die Batterie 110 einen gewissen Innenwiderstand 112 auf, welcher in dem in Figur 1 dargestellten Blockschaltbild mit $R_I$ gekennzeichnet ist. Außerdem stellen die nicht näher dargestellten Anschlüsse bzw. Anschlusskabel der Batterie 110 einen ebenfalls nicht verschwindenden Anschlusswiderstand dar 114 dar, welcher mit $R_K$ gekennzeichnet ist.

Wie aus Figur 1 ersichtlich, ist die Batterie 110 mit der Brandmeldezentrale 102 und mit dem Stromversorgungsnetz 140 über eine Schaltungsanordnung 120 verbunden. Die Verbindung der Schaltungsanordnung 120 mit der Batterie 110 erfolgt über einen Eingang 121.

Gemäß dem hier dargestellten Ausführungsbeispiel erfüllt die Schaltungsanordnung 120 zwei Aufgaben:

A) Eine erste Aufgabe besteht darin, den Ladezustand des Akkus 110 zu überwachen und bei Bedarf eine Wiederaufladung des Akkus 110 zu veranlassen. Für diesen Zweck ist in der Schaltungsanordnung 120 eine Einheit 129 vorgesehen, welche sowohl die Funktion einer Zentraleinspeiseeinheit als auch die Funktion einer Akkuladeeinheit erfüllt. In diesem Zusammenhang wird darauf hingewiesen, dass bei einem Bleiakku eine kontinuierliche Aufladung erfolgt. Nach dem eigentlichen Ladevorgang geht man in eine Erhaltungsladung über, bei der der Ladezustand des Akkus beibehalten wird.

B) Eine zweite Aufgabe besteht darin, den Innen- und Anschlusswiderstand der Batterie 110 in regelmäßigen Abständen zu überprüfen. Dadurch kann nämlich der Alterungszustand der Batterie 110 regelmäßig überprüft werden und für den Fall, dass ein erhöhter Innenwiderstand auf eine nicht mehr vorhandenen Tauglichkeit der Batterie 110 als elektrischer Energiespeicher hinweist, ein Austausch der Batterie 110 veranlasst werden.

Um den Innen- und Anschlusswiderstand der Batterie 110 zu messen, ist in der Schaltungsanordnung 120 ein Messwiderstand 122 vorgesehen, welcher in dem in Figur 1 dargestellten Blockschaltbild mit $R_M$ gekennzeichnet ist. Ferner sind zwei Schalter, ein erster Schalter 126, welcher mit S1 gekennzeichnet ist, und ein zweiter Schalter 127 vorgesehen, welcher in Figur 1 mit S2 gekennzeichnet ist. Die beiden Schalter 126 und 127 sind mit einer Steuereinheit 128 gekoppelt, welche die Messung des Innen- und Anschlusswiderstandes der Batterie 110 durch eine geeignete zeitliche Ansteuerung der Schalter 126 und 127 steuert. Ferner weist die Schaltungsanordnung 120 noch einen Messfühler 124 auf, welcher eine an dem Messwiderstand 122 abfallende Messspannung $U_A$ erfasst. Der Spannungsabfall $U_A$ wird dabei durch einen Messstrom erzeugt, welcher von der Batterie 110, deren Minuspol mit der Masse GND verbunden ist, bei geschlossenem Schalter 126 über den Messwiderstand 122 zu der Masse GND fließt.

Gemäß dem hier dargestellten Ausführungsbeispiel liefert die Batterie 110 eine Spannung von ca. 24 Volt. Ferner weist der Messwiderstand einen Widerstand von 90 Ohm auf, so dass bei geschlossenem Schalter ein Messstrom von ungefähr 270 mA durch den Messwiderstand fließt. Daraus ergibt sich in erster Näherung eine thermische Verlustleistung von ungefähr 0,27 A x 24 Volt = 6,4 Watt.

Gemäß dem hier dargestellten Ausführungsbeispiel der Erfindung weist der Messwiderstand mit einer Nennleistung von ungefähr 5 Watt eine Leistung auf, welche deutlich kleiner ist als die tatsächliche Verlustleistung während des Messvorgangs. Diese Verlustleistung wird jedoch nur dann in dem Messwiderstand 122 erzeugt, wenn der Schalter 126 geschlossen ist. Eine thermische Beschädigung des Messwiderstandes 122 wird jedoch dadurch vermieden, dass der Schalter 126 nur für einen vergleichsweise kurzen Zeitraum von ungefähr 300 ms geschlossen wird. Innerhalb dieser kurzen Zeit gerät der Messwiderstand 122 nicht in ein thermisches Gleichgewicht. Bevor eine Beschädigung des Messwiderstandes 122 zu besorgen wäre, wird der Schalter 126 geöffnet und damit der Messstrom abrupt unterbrochen.

An dieser Stelle wird ausdrücklich darauf hingewiesen, dass der Widerstandswert des Messwiderstands 122 mit 90 Ohm im Vergleich zu dem ungefähr zu erwarteten Innen- und Anschlusswiderstand 112 und 114 der Batterie 110 mit ungefähr 1 Ohm relativ groß ist. In diesem Aspekt unterscheidet sich das in dieser Anmeldung beschriebene Messverfahren von bekannten Verfahren zur Bestimmung des Innenwiderstands einer Spannungsquelle. Bei bekannten Verfahren wird nämlich typischerweise ein Messwiderstand verwendet, welcher hinsichtlich seines Widerstandswertes die gleiche Größenordnung wie der ungefähr zu erwartende Messwiderstand aufweist.

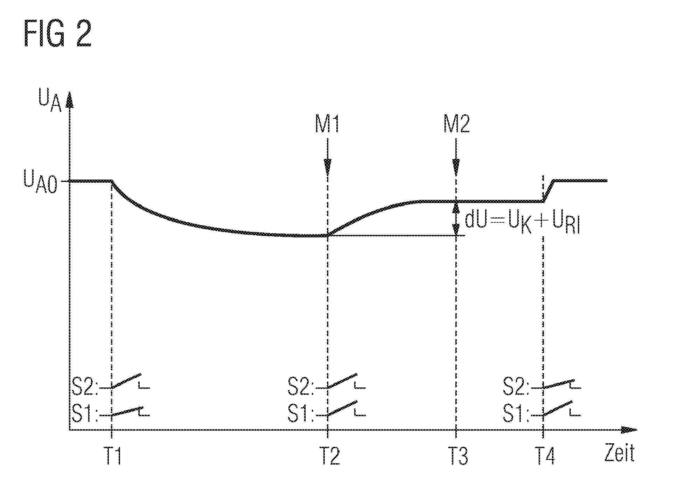

Im Folgenden wird der Messvorgang gemäß einem bevorzugten Ausführungsbeispiel der Erfindung insbesondere anhand von Figur 2 näher erläutert.

Im Normalzustand der Schaltungsanordnung 120 ist der erste Schalter 126 geöffnet und der zweite Schalter 127 geschlossen. Dies bedeutet, dass die Brandmeldezentrale 102 von dem Stromnetz 140 mit elektrischer Energie versorgt wird. Gleichzeitig sorgt die Akkuladeeinheit 129 für eine ggf. erforderliche Aufladung bzw. für eine Ladungserhaltung der Batterie 110. An dem Messfühler wird eine Spannung $U_{A0}$ gemessen.

Zum Zeitpunkt T1 wird der erste Schalter 126 geschlossen und gleichzeitig der zweite Schalter 127 geöffnet. Dadurch kann ein Messstrom durch den Messwiderstand 122 fließen, welcher infolge von insbesondere kapazitiven Effekten einen durch eine Exponentialkurve beschriebenen Einschwingvorgang durchläuft. Dementsprechend wird der Messfühler 124 an dem Messwiderstand 122 eine exponentiell abfallende Messspannung $U_A$ erfassen. Der Messstrom verursacht außerdem an dem Anschlusswiderstand 114 einen Spannungsabfall $U_K$ und an dem Innenwiderstand 112 einen Spannungsabfall $U_{RI}$.

Nach einer vorgegebenen Zeitspanne zum Zeitpunkt T2, an dem (a) eine thermische Überhitzung des Messwiderstandes 122 noch nicht eingetreten ist und an dem (b) der kapazitive Einschwingvorgang der Messspannung $U_A$ zumindest annähernd abgeschlossen ist, erfolgt eine erste Spannungsmessung M1. Dabei wird ein Messwert $U_A(T_2)$ erfasst. Unmittelbar nach der Messung M1 wird der erste Schalter 126 geöffnet und dadurch der Messstrom durch den Messwiderstand 122 abrupt unterbrochen. Der zweite Schalter 127 bleibt zunächst weiter geöffnet.

Durch die abrupte Unterbrechung des Messstroms werden erneut insbesondere kapazitiven Effekte der Batterie deutlich. Infolge der Stromunterbrechung kann weder an dem Anschlusswiderstand 114 noch an dem Innenwiderstand 112 ein Spannungsabfall auftreten, so dass die effektive Batteriespannung, die durch den Messfühler 124 gemessen wird, wieder größer wird. Dies bedeutet jedoch, dass die parasitäre Kapazität der Batterie nach der durch die Stromunterbrechung verursachte Spannungserhöhung mit einer charakteristischen Zeitkonstante wieder aufgeladen wird. Dementsprechend wird die Spannung $U_A$ ab dem Zeitpunkt T2 wieder ansteigen.

Zu einem späteren Zeitpunkt T3, zu dem der durch die Aufladung der parasitären Kapazitäten der Batterie 110 verursachte Aufladevorgang weitgehend abgeschlossen ist, wird eine zweite Messung M2 durchgeführt, bei der die Spannung $U_B$ der Batterie 110 im stromlosen Zustand gemessen wird. Diese zweite Messung liefert einen Messwert $U_A(T_3)$, welcher der Batteriespannung $U_B$ entspricht.

Der Spannungsunterschied zwischen dem strombehafteten Zustand zum Zeitpunkt T2 und dem stromlosen Zustand zum Zeitpunkt T3 ist in Figur 2 mit dU gekennzeichnet. Der Spannungsunterschied dU entspricht somit der Summe aus den Spannungsabfällen $U_{RI}$ am Innenwiderstand und $U_K$ an Kabel und Anschlüsse der Batterie 110.
Durch eine einfache statische Betrachtung der Spannungsteilung im strombehafteten Zustand zum Zeitpunkt T2 ergibt sich folgende Beziehung:

$$U_A : R_M \;=\; (U_B - U_M) : (R_I + R_K)$$

Diese Beziehung kann nach den gesuchten Innen- und Anschlusswiderstand der Batterie 110 aufgelöst werden. Dabei ergibt sich folgende Gleichung:

$$R_I + R_K \;=\; [R_M / U_A(T_2)] \;\times\; [U_A(T_3) \;-\; U_A(T_2)]$$

Aus dieser Gleichung kann dann auf einfache Weise der gesuchte Innen- und Anschlusswiderstand $R_I + R_K$ der Batterie 110 bestimmt werden.
Zu einem Zeitpunkt T4 wird dann der zweite Schalter S2 geschlossen, der erste Schalter S1 bleibt weiterhin geöffnet. Durch das Schließen des zweiten Schalters S2 wird die Akkuladeeinheit 129 wieder angekoppelt, so dass zum Zwecke einer Aufladung der Batterie 110 die Spannung an dem Messfühler wieder auf die ursprüngliche Messspannung $U_{A0}$ im Normalzustand ansteigt.
Der beschriebe Messvorgang kann in periodischen Abständen wiederholt und somit der Alterungszustand der Batterie 110 regelmäßig überprüft werden. Dabei ist jedoch darauf zu achten, dass der Zeitabstand zwischen zwei aufeinanderfolgenden Messungen so lang ist, dass eine thermische Überlastung des Messwiderstandes 122 nicht auftreten kann.

**Patentansprüche**

1. Verfahren zum Bestimmen des Innen- und Anschlusswiderstandes einer Batterie (110), insbesondere einer Batterie (110) für die Netzspeisung einer Zentrale (102) und/oder Peripherieeinheit (103) eines Gefahrmeldesystems (100), das Verfahren aufweisend

   • vorübergehendes Belasten der Batterie (110) mit einem Messstrom, welcher über einen Messwiderstand (122) geleitet wird,
   • Messen der an dem Messwiderstand (122) abfallenden Spannung ($U_A$), und
   • Bestimmen des Innen- und Anschlusswiderstandes ($R_I + R_K$) der Batterie (110) basierend auf der gemessenen Spannung ($U_A$),

   wobei
   der Messstrom zu einer vorübergehenden Belastung des Messwiderstands (122) mit einer Messleistung führt, welche größer ist als die Nennleistung des Messwiderstands (122).

2. Verfahren nach Anspruch 1, bei dem
   während der Belastung der Batterie (110) mit dem Messstrom ein an der Batterie (110) angeschlossener Verbraucher abgekoppelt wird.

3. Verfahren nach einem der Ansprüche 1 bis 2, bei dem
   der Messwiderstand (122) einen Widerstandswert aufweist, welcher um einen Faktor 10, insbesondere um einen Faktor 50 und bevorzugt um einen Faktor 100 größer ist als der zu erwartende Innen- und Anschlusswiderstand ($R_I + R_K$) der Batterie (110).

4. Verfahren nach einem der Ansprüche 1 bis 3, bei dem während des Belastens der Batterie (110) mit dem Messstrom eine Überwachung auf einen Ausfall eines Stromversorgungsnetzes (140) erfolgt.

5. Verfahren nach einem der Ansprüche 1 bis 4, wobei der Messvorgang für die an dem Messwiderstand (122) abfallende Spannung ($U_A$) relativ zu dem Beginn der Belastung der Batterie (110) mit dem Messstrom mit einer vorbestimmten ersten zeitlichen Verzögerung erfolgt.

6. Verfahren nach einem der Ansprüche 1 bis 5, wobei die Zeitdauer des Messstroms so gewählt wird, dass die resultierende Wärmebelastung des Messwiderstands (122) in einem für den Messwiderstand (122) tolerierbaren Bereich liegt.

7. Verfahren nach einem der Ansprüche 1 bis 6, zusätzlich aufweisend

• Unterbinden eines Stromflusses durch den Messwiderstand (122) und
• Messung der Spannung ($U_B$) der Batterie (110) im stromlosen Zustand.

8. Verfahren nach Anspruch 7, wobei die Berechnung des Innen- und des Anschlusswiderstandes ($R_I$+$R_K$) nach der Formel

$$R_I + R_K = [R_M / U_A(T_2)] \times [U_A(T_3) - U_A(T_2)]$$

erfolgt, in welcher

$R_I$ der Innenwiderstand der Batterie,
$R_K$ der Widerstand von Kabel und Anschlüsse der Batterie,
$U_A(T_2)$ die Spannung über dem mit dem Messstrom belasteten Messwiderstand und
$U_A(T_3)$ die Batteriespannung im stromlosen Zustand

ist.

9. Verfahren nach einem der Ansprüche 7 bis 8, wobei
der Messvorgang für die Spannung ($U_B$) der Batterie (110) im stromlosen Zustand relativ zu der Unterbindung des Stromflusses durch den Messwiderstand (122) in einer vorbestimmten zweiten zeitlichen Verzögerung erfolgt.

10. Schaltungsanordnung zum Bestimmen des Innen- und Anschlusswiderstandes ($R_I$+$R_K$) einer Batterie (110), insbesondere zum Durchführen des Verfahrens nach einem der Ansprüche 1 bis 8, die Schaltungsanordnung (120) aufweisend

• einen Eingang (121) zum Verbinden der Schaltungsanordnung (120) mit der Batterie (110),
• einen Messwiderstand (122) zum Belasten der Batterie (110) mit einem Messstrom, und
• einen ersten Schalter (126) zum vorübergehenden Schließen eines Stromkreises, so dass der Messstrom fließen kann,

wobei
der Messstrom zu einer vorübergehenden Belastung des Messwiderstands (122) mit einer Messleistung führt, welche größer ist als die Nennleistung des Messwiderstands (122).

11. Schaltungsanordnung nach Anspruch 10, zusätzlich aufweisend

• einen zweiten Schalter (127) zum vorübergehenden Abkoppeln von elektronischen Komponenten, welche üblicherweise mit der Batterie (110) verbunden sind.

12. Schaltungsanordnung nach einem der Ansprüche 10 bis 11,
wobei
der Messwiderstand (122) mittels einer Kombination von mehreren Einzelwiderständen realisiert ist.

13. Gefahrmeldesystem zum Erkennen und/oder Beseitigen einer Gefahrensituation, insbesondere in einem Gebäude, das Gefahrmeldesystem (100) aufweisend

• eine Zentrale (102) und/oder eine Peripherieeinheit (103),

• eine Batterie (110) zum Versorgen der Zentrale (102) und/oder der Peripherieeinheit (103) mit elektrischer Energie, und
• eine Schaltungsanordnung (120) nach einem der Ansprüche 10 bis 12 zum Bestimmen des Innen- und Anschlusswiderstandes ($R_I+R_K$) der Batterie (110).

FIG 1

EP 2 051 088 A1

## FIG 2

**Europäisches Patentamt**

## EUROPÄISCHER RECHERCHENBERICHT

**Nummer der Anmeldung**

EP 07 11 8689

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | EP 1 619 512 A (BPPOWER INC [TW]) 25. Januar 2006 (2006-01-25) * das ganze Dokument * ----- | 1-13 | INV. G01R31/36 G01R1/20 G08B13/00 |
| Y | VITROHM: "Impulsbelastbarkeiten von Drahtwiderständen" 21. Februar 2006 (2006-02-21), XP002473929 Gefunden im Internet: URL:http://www.vitrohm.com/files_stat/Impulsbelastbarkeiten_Drahtwiderstaende.pdf> * das ganze Dokument * ----- | 1-13 | |
| A | EP 1 378 757 A (SIEMENS AG [DE]) 7. Januar 2004 (2004-01-07) * Absatz [0006] * ----- | 1-13 | |
| A | WO 92/22883 A (RUUS JAN [SE]) 23. Dezember 1992 (1992-12-23) * Zusammenfassung * * Seite 5, Absatz 3 * ----- | 13 | |

| RECHERCHIERTE SACHGEBIETE (IPC) |
|---|
| G01R G08B |

Der vorliegende Recherchenbericht wurde für alle Patentansprüche erstellt

| Recherchenort | Abschlußdatum der Recherche | Prüfer |
|---|---|---|
| Den Haag | 26. März 2008 | Koll, Hermann |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 07 11 8689

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-03-2008

| Im Recherchenbericht angeführtes Patentdokument | | Datum der Veröffentlichung | Mitglied(er) der Patentfamilie | | Datum der Veröffentlichung |
|---|---|---|---|---|---|
| EP 1619512 | A | 25-01-2006 | CN | 1725025 A | 25-01-2006 |
| | | | JP | 2006038859 A | 09-02-2006 |
| | | | KR | 20060046537 A | 17-05-2006 |
| EP 1378757 | A | 07-01-2004 | DE | 10229895 B3 | 08-04-2004 |
| WO 9222883 | A | 23-12-1992 | AU | 672174 B2 | 26-09-1996 |
| | | | AU | 2022692 A | 12-01-1993 |
| | | | CA | 2111226 A1 | 23-12-1992 |
| | | | EP | 0591292 A1 | 13-04-1994 |
| | | | FI | 935568 A | 10-12-1993 |
| | | | NO | 934559 A | 10-12-1993 |
| | | | SE | 9101786 A | 13-12-1992 |

EPO FORM P0461

Für nähere Einzelheiten zu diesem Anhang : siehe Amtsblatt des Europäischen Patentamts, Nr.12/82